# DEMANDE DE BREVET EUROPEEN

(11) **EP 4 293 564 A1**
(43) Date de publication de la demande: **20.12.2023**
(21) Numéro de dépôt: 23179273.0
(22) Date de dépôt: 14.06.2023
(51) Int. Cl.: G06F 30/398, G06F 30/33

(54) **CALENDRIER DE FAUTES POUR ACCÉLÉRATION DE L'ANALYSE DE FIABILITÉ DES CIRCUITS INTÉGRÉS**

(30) Priorité: 15.06.2022 FR 2205817
(71) Demandeur: COMMISSARIAT À L'ÉNERGIE ATOMIQUE ET AUX ÉNERGIES ALTERNATIVES, 75015 Paris (FR)
(72) Inventeur: BUREL, Stéphane, 38054 Grenoble (FR); EVANS, Adrian, 38054 Grenoble (FR)
(74) Mandataire: Atout PI Laplace

(57) **Abrégé**

L'invention concerne un procédé, mis en oeuvre par ordinateur, de test de fiabilité d'un circuit comprenant un ensemble de composants électroniques, ledit ensemble comprenant une pluralité d'unités de traitement configurés pour exécuter en parallèle des opérations de calcul selon un ordonnancement statique parallèle prédéterminé. Ledit procédé comprenant les étapes suivantes :
i. recevoir une distribution des opérations de calcul selon l'ordonnancement statique ;
ii. recevoir au moins un modèle de fautes appliqué à l'ordonnancement statique ;
iii. générer une séquence d'exécution en série à partir de l'ordonnancement statique parallèle ;
iv. générer un calendrier d'injection de fautes ;
v. exécuter la séquence d'exécution en série avec injection de faute à partir du calendrier de fautes par un processeur ;
vi. évaluer le résultat final de l'exécution par rapport à un résultat attendu.

## Description

### Champ d'application

La présente invention concerne le domaine du test de fiabilité des circuits intégrés de calcul. Plus particulièrement, l'invention concerne l'analyse de fiabilité de circuits numériques de calculateurs parallèles par simulation d'injection de fautes.

### Problème soulevé

Les circuits de calcul parallèle sont utilisés dans des applications assujetties à des contraintes strictes de sûreté de fonctionnement. Pour obtenir des performances de calcul élevées, ces circuits sont accélérés en effectuant des opérations de calcul en parallèle. Ce type de calculateur est largement utilisé dans des systèmes critiques. Pour des systèmes critiques, pendant la phase de conception, il est obligatoire d'évaluer la tolérance du système aux fautes matérielles. L'analyse de fiabilité comprend ainsi des simulations d'injections de fautes.

On entend par « injection de fautes » une technique de test de fiabilité d'un circuit intégré en simulant son comportement en présence de fautes matérielles injectées lors de l'exécution de l'application mise en oeuvre par le circuit intégré. Le principe repose sur la comparaison du comportement nominal du circuit (sans faute) avec son comportement en présence des fautes. Plusieurs modèles de fautes peuvent être injectés en faisant varier le type de fautes, l'instant d'injection lors de l'exécution et les composants impactés par les fautes.

L'approche usuelle de test de fiabilité par injection de faute, consiste à injecter les fautes dans des simulations de la modélisation du circuit numérique de type RTL (acronyme de l'expression anglaise Register Transfer Level). Il s'agit d'une méthode de description des architectures microélectroniques basées sur une modélisation au niveau des bascules et des fonctions de logique combinatoire. Cette approche assure une modélisation qui est proche du comportement réel du circuit mais présente des temps de simulation assez longs. En effet, l'injection de faute avec une modélisation RTL nécessite l'injection de fautes en forçant des noeuds à des valeurs prédéterminées dans le modèle RTL et le lancement de simulations numériques de la réponse du circuit avec des stimuli prédéterminés. Ce type de simulation est très long car les calculs sont réalisés au niveau des bascules et des fonctions logiques.

Le problème technique consiste à analyser l'impact des fautes dans une architecture de calcul parallèle. Il faut que cette analyse soit rapide, pour analyser un grand nombre de fautes, et il faut qu'elle reflète le comportement réel du matériel en présence d'une faute. Ainsi, il existe un besoin pour développer un procédé de test de fiabilité d'un circuit par injection de fautes, combinant la réduction des temps de simulation avec une bonne précision permettant de prédire le vrai comportement du circuit en présence de fautes.

### Art antérieur/ Restrictions de l'état de l'art

La publication scientifique « gem5-FIM: A flexible and scalable multicore soft error assessment framework to early reliability design space explorations » de Rocha da Rosa présente une méthode d'évaluation de l'impact des fautes dans des calculateurs avec un architectures multi-coeurs ou multi-CPUs. Cependant, cette solution s'appuie sur la valeur d'un pointeur d'instruction (instruction pointé ou program counter en anglais) pour déterminer quand les fautes doivent être injectées. L'utilisation d'un pointeur d'instruction n'est pas compatible avec des architectures parallèles à ordonnancement fixe.

La publication scientifique « Analyzing and mitigating the impact of permanent faults on a systolic array based neural network accelerator » de Zhang et al présente une méthode d'évaluation de l'impact des fautes en utilisant des simulations numériques d'un circuit calculateur. Cette méthode est appliquée à des modèles du circuit électronique de type RTL. Un inconvénient de cette solution est un temps de simulation élevé car l'injection de faute est appliquée à un bas niveau d'abstraction.

### Réponse au problème et apport solution

Pour pallier les limitations des solutions existantes en ce qui concerne l'amélioration des tests de fiabilité par injection de fautes de circuits de calcul en parallèle, l'invention propose une nouvelle méthode permettant d'effectuer cette analyse au niveau logiciel au lieu de travailler au niveau de la modélisation matérielle (RTL). L'invention repose sur la génération d'une séquence d'exécution en série des opérations de calcul destinées à être effectuées parallèlement par le circuit testé. Cette séquence en série produit un résultat identique à celui obtenu avec l'exécution parallèle. Cette séquence est simulée à haut niveau, potentiellement directement par un processeur classique, ce qui permet un gain important en temps d'exécution. Le coeur de l'invention consiste en la génération, d'une structure de données, nommé calendrier de fautes. Pour une séquence d'une ou plusieurs fautes dans l'architecture parallèle, ce calendrier indique les numéros des étapes correspondantes dans la séquence en série. Grâce à ce calendrier, il est possible d'injecter les fautes pendant la simulation à haut niveau, tout en obtenant un comportement identique à celui qui aurait été obtenu sur l'architecture parallèle.

Le mécanisme de test selon l'invention assure que le résultat de la simulation haut niveau reste fidèle au comportement d'une analyse matérielle au niveau circuit. De plus, l'invention présente l'avantage de gagner une accélération de l'ordre de 100 fois par rapport aux simulations RTL.

Cette solution permet ainsi de réduire le temps de simulation et donc la durée de validation de robustesse pendant la phase de conception d'un circuit intégré présentant des contraintes strictes de sûreté fonctionnelle. Cette accélération ne se fait pas au détriment de la précision des analyses qui reste aussi fidèle que celles faites au niveau RTL.

De plus, le procédé selon l'invention présente l'avantage d'une compatibilité avec les applications de type accélérateur de calcul pour la mise en oeuvre d'un réseau de neurones artificiels.

De plus, le procédé selon l'invention présente l'avantage d'un simple mécanisme d'injection de fautes de différents types. On liste à titre d'exemple les fautes de blocage d'un bit à un état logique, les fautes d'inversement de l'état logique d'un bit et les fautes de court-circuit. Grâce à une simulation plus rapide, le procédé selon l'invention permet de multiplier le nombre de simulations de fautes de manière à mieux évaluer l'impact des fautes sur le circuit à tester.

De plus, le procédé selon l'invention permet de simuler des modèles de fautes non déterministes où au moins un paramètre de la faute injecté est aléatoire.

### Résumé /Revendications

L'invention a pour objet un procédé, mis en oeuvre par ordinateur, de test de fiabilité d'un circuit comprenant un ensemble de composants électroniques, ledit ensemble comprenant une pluralité d'unités de traitement de rang i=1 à N et configurés pour exécuter en parallèle des opérations de calcul selon un ordonnancement statique parallèle prédéterminé. Ledit procédé comprend les étapes suivantes :
i- recevoir une distribution des opérations de calcul selon l'ordonnancement statique ;
ii- recevoir au moins un modèle de fautes appliqué à l'ordonnancement statique ;
iii- générer une séquence d'exécution en série à partir de l'ordonnancement statique parallèle ;
iv- générer un calendrier d'injection de fautes ;
v- exécuter la séquence d'exécution en série avec injection de faute à partir du calendrier de fautes par un processeur ;
vi- évaluer le résultat final de l'exécution par rapport à un résultat attendu.

Selon un aspect particulier de l'invention, l'injection de faute lors de l'exécution de la séquence d'exécution est déclenchée par un compteur configuré pour compter le nombre d'opérations de calcul prévues entre l'injection d'une faute et l'injection de la faute suivante.

Selon un aspect particulier de l'invention, chaque faute du modèle de fautes est caractérisée par trois paramètres : au moins un composant électronique du circuit impacté par la faute, un type de faute et un instant d'injection de la faute dans l'ordonnancement statique prédéterminé.

Selon un aspect particulier de l'invention, l'étape iii) comprend les sous-étapes suivantes :
iii.a) identifier chaque opération de calcul par un premier indice correspondant au rang de l'unité de traitement exécutant ladite opération et par un second indice correspondant à l'instant d'exécution de ladite opération selon l'ordonnancement statique parallèle ;
iii.b) déterminer pour chaque opération de calcul un ensemble des composants utilisés lors de l'exécution de ladite opération ;
iii.c) générer un calendrier de fautes en associant à chaque faute du modèle au moins une opération de calcul selon la comparaison entre :
   - d'une part l'ensemble des composants impactés par ladite faute et d'autre part l'ensemble des composants utilisés par l'au moins opération de calcul.

Selon un aspect particulier de l'invention, la séquence d'exécution en série est décomposée en deux groupes de sous-séquences, les opérations de calcul associées à des fautes étant disposées dans les sous-séquences du premier groupe. Chaque sous-séquence d'exécution du premier groupe étant exécutée lors de l'étape v) par un processeur de type unité centrale de traitement (CPU). Chaque sous-séquence d'exécution (S1b) du second groupe étant exécutée lors de l'étape v) par un processeur graphique (GPU).

Selon un aspect particulier de l'invention, l'injection de fautes lors de l'étape v) est réalisée par l'application d'une opération de masquage logique sur une donnée d'entrée ou une donnée de sortie de l'opération de calcul associées à la dite faute.

Selon un aspect particulier de l'invention, le type d'une faute est choisi parmi le blocage d'un noeud à un état logique, l'inversement de l'état logique d'un bit, le court-circuit d'une connexion électrique.

Selon un aspect particulier de l'invention, le composant impacté par la faute est une unité de traitement ou une mémoire de stockage ou une connexion électrique ou un réseau de distribution d'un signal horloge.

Selon un aspect particulier de l'invention, au moins un des paramètres modèle de fautes est généré d'une manière aléatoire.

Selon un aspect particulier de l'invention, le circuit est configuré pour mettre en oeuvre un réseau de neurones artificiels, et dans lequel les unités de traitement sont des circuits multiplieurs accumulateurs configurés pour calculer des sommes de données pondérées par des coefficients synaptiques.

L'invention a également pour objet un dispositif de test de fiabilité d'un circuit comprenant un ensemble de composants électroniques, ledit ensemble comprenant une pluralité d'unités de traitement de rang i=1 à N et configurés pour exécuter en parallèle des opérations de calcul selon un ordonnancement statique parallèle prédéterminé ledit dispositif étant configuré pour exécuter les étapes du procédé selon l'invention.

Selon un aspect particulier de l'invention, le dispositif de test comprend un processeur de type unité centrale de traitement et un processeur graphique. Le dispositif de test étant configuré pour exécuter les étapes du procédé.

L'invention a également pour objet un programme d'ordinateur comprenant des instructions qui, lorsque le programme d'ordinateur est exécuté par le dispositif de test selon l'invention, conduisent ledit dispositif de test à mettre en oeuvre le procédé de test selon l'invention.

### Description détaillée

D'autres caractéristiques et avantages de la présente invention apparaîtront mieux à la lecture de la description qui suit en relation aux dessins annexés suivants.
[Fig. 1a] la figure 1a illustre un exemple d'un circuit intégré configuré pour exécuter en parallèle des opérations de calcul.
[Fig. 1b] la figure 1b illustre une unité de traitement de la matrice de calcul du circuit intégré.
[Fig. 1c] la figure 1c illustre un organigramme de la méthode de test selon l'invention.
[Fig. 2] la figure 2 illustre l'ordonnancement statique des opérations de calcul effectuées en parallèle par un exemple de circuit intégré testé par le procédé selon l'invention.
[Fig. 3a] la figure 3a illustre un premier exemple d'un modèle de faute compatible avec le procédé selon l'invention. Dans cet exemple, la faute touche une seule opération.
[Fig. 3b] la figure 3b illustre un deuxième exemple d'un modèle de faute compatible avec le procédé selon l'invention.
[Fig. 3c] la figure 3c illustre un troisième exemple d'un modèle de faute compatible avec le procédé selon l'invention. Dans cet exemple, deux fautes touchent deux unités de calcul en même temps.
[Fig. 3d] la figure 3d illustre un quatrième exemple d'un modèle de faute compatible avec le procédé selon l'invention.
[Fig. 4a] la figure 4a illustre un premier exemple de la génération d'une séquence d'exécution en série à partir de l'ordonnancement statique parallèle selon l'invention.
[Fig. 4b] la figure 4b illustre un second exemple de la génération d'une séquence d'exécution en série à partir de l'ordonnancement statique parallèle selon l'invention.
[Fig. 5a] la figure 5a illustre un organigramme des sous-étapes de la génération du calendrier de fautes dans le procédé selon l'invention.
[Fig. 5b] la figure 5b illustre un mode de réalisation du calendrier de faute selon l'invention.
[Fig. 6a] la figure 6a illustre un premier exemple une séquence d'exécution en série des opérations de calcul avec une injection de fautes selon le calendrier selon l'invention.
[Fig. 6b] la figure 6b illustre un organigramme du mécanisme de contrôle de l'injection de fautes selon l'invention.
[Fig. 6c] la figure 6c illustre un second exemple d'une séquence d'exécution en série des opérations de calcul avec une injection de fautes selon le calendrier selon l'invention.
[Fig. 6d] la figure 6d illustre un troisième exemple d'une séquence d'exécution en série des opérations de calcul avec une injection de fautes selon le calendrier selon l'invention.
[Fig. 6e] la figure 6e illustre un quatrième exemple d'une séquence d'exécution en série des opérations de calcul avec une injection de fautes selon le calendrier selon l'invention.
[Fig. 7] la figure 7 illustre une séquence d'exécution en série des opérations de calcul avec une injection de fautes selon le calendrier selon un second mode de réalisation l'invention.

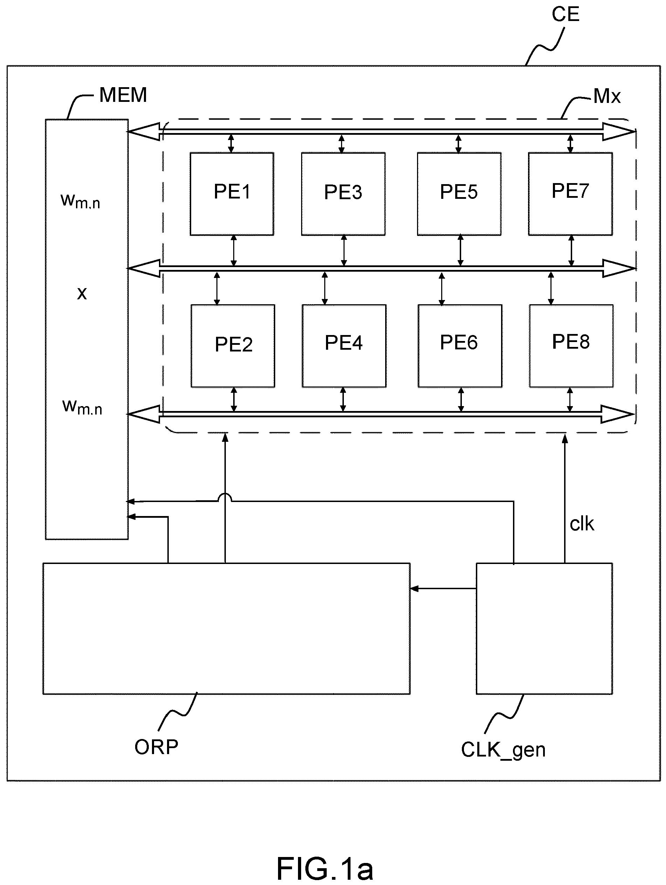

La figure 1a illustre un exemple d'un circuit intégré CE configuré pour exécuter des opérations de calcul en parallèle. Le circuit intégré CE comprend un circuit d'ordonnancement ORD, un étage mémoire MEM, une matrice d'unités de calcul Mx et un circuit de génération d'un signal horloge CLK_gen.

La matrice d'unités de calcul Mx comprend une pluralité d'unités de traitement PEᵢ avec i un entier allant de 1 à N. Chaque unité de traitement PEᵢ est configurée pour réaliser des opérations de calcul élémentaires à partir d'opérandes d'entrée. Les opérandes d'entrée des unités de traitement PE sont stockés dans l'étage mémoire MEM. Il est aussi envisageable pour une unité de traitement PE; de recevoir un opérande fourni par une autre unité de traitement PEⱼ. Les données de sortie des opérations de calcul exécutées par les unités de traitement sont stockées dans l'étage mémoire MEM.

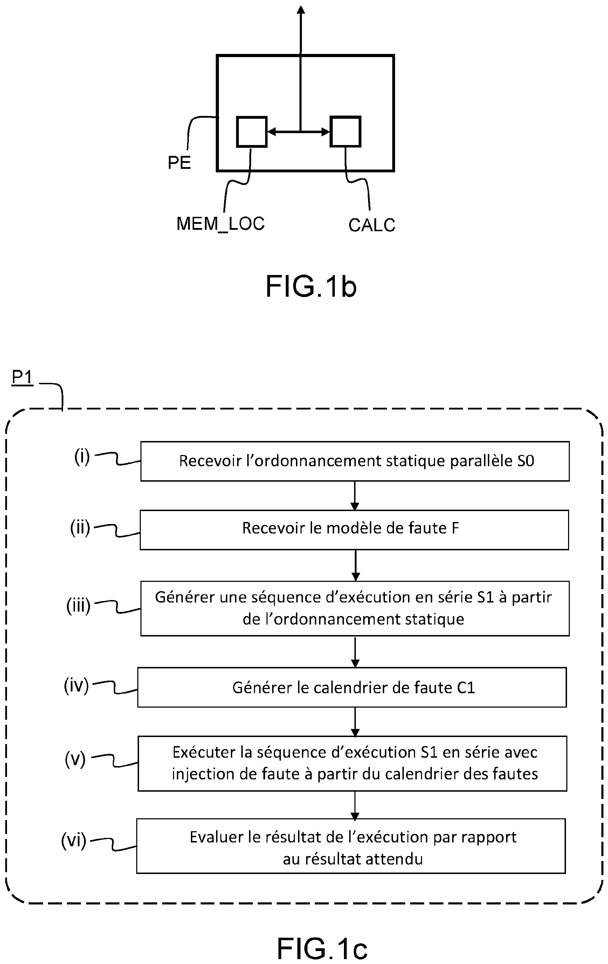

Plus particulièrement, des unités de traitement PE; peuvent former un groupe partageant en outre une mémoire intermédiaire et un réseau d'interconnexion local entre les unités de traitement formant ledit groupe. De plus, la figure 1b illustre l'architecture d'une unité de traitement PEᵢ de la matrice Mx. Chaque unité de traitement PEᵢ comprend une mémoire locale MEM_LOC pour stocker temporairement les opérandes et/ou les résultats et une unité de calcul CALC pour réaliser les opérations de calcul élémentaires.

Le circuit d'ordonnancement ORD est configuré pour organiser l'ordre d'exécution des opérations de calcul par les unités de traitement et les opérations de lecture et écriture dans l'étage mémoire MEM. Le fonctionnement du circuit intégré CE est cadencé par un signal d'horloge clk généré par le circuit de génération CLK_gen.

Afin d'améliorer la vitesse d'exécution des opérations de calcul, le circuit d'ordonnancement ORD configure la distribution des données vers les unités de traitement PEᵢ de manière à réaliser des opérations de calcul d'une façon parallèle pendant le même cycle d'horloge. On entend par « distribution spatiale », la distribution des opérations de calcul entre les unités de traitement PEᵢ pour un cycle d'horloge prédéterminé. On entend par « distribution temporelle », la distribution des opérations de calcul au cours du temps pour une unité de traitement PE; prédéterminée. Lorsque l'ordonnancement des opérations de calcul est régi par une distribution temporelle et une distribution spatiale fixes, on parle d'ordonnancement statique. Pour chaque opération de calcul, le temps d'exécution et l'unité de traitement effectuant l'opération sont fixes.

D'une manière générale, le procédé de test selon l'invention est applicable à tout circuit intégré comprenant une pluralité d'unités de traitement configurée pour exécuter en parallèle des opérations de calcul selon un ordonnancement statique prédéterminé. L'exemple de la figure 1a est donné à titre illustratif et non-limitatif.

A titre d'exemple non limitatif, le circuit intégré CE est configuré pour mettre en oeuvre un réseau de neurones artificiels. Les unités de traitements au sein des PEᵢ sont des circuits multiplieurs-accumulateurs configurés pour calculer des sommes de données notées xₖ pondérées par des coefficients synaptiques w_{m,n}. Le circuit intégré CE est ainsi apte à réaliser une pluralité d'opérations de multiplications et d'accumulations pendant un seul cycle d'horloge clk. Les résultats de ces opérations de calcul correspondent à des résultats partiels utilisés pour le calcul d'un produit convolutionnel d'une matrice d'entrée par un filtre de poids synaptiques. Alternativement, le circuit est configuré pour calculer parallèlement un réseau de neurones artificiels ayant des couches de neurones entièrement connectées.

La figure 1c illustre un organigramme du procédé de test P1 selon l'invention. Le procédé P1 est un procédé mis en oeuvre par ordinateur visant à tester la fiabilité d'un circuit intégré comprenant une pluralité d'unités de traitement configurée pour exécuter en parallèle des opérations de calcul selon un ordonnancement statique prédéterminé.

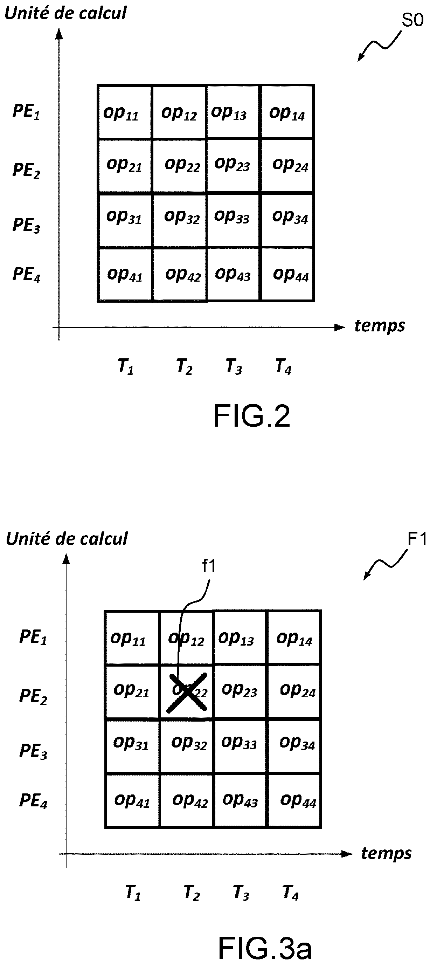

La première étape i) consiste à recevoir l'ordonnancement statique S0 des opérations de calcul op_{i,j} par le circuit électronique CE mettant en oeuvre le procédé P1. La figure 2 illustre un exemple de l'ordonnancement statique S0 des opérations de calcul op_{i,j} effectuées en parallèle par une matrice d'unités de traitement. A titre d'exemple non limitatif, la matrice d'unités de traitement comprend N=4 unités de traitement PE. L'algorithme mis en oeuvre par le circuit testé est réalisé pendant quatre cycles d'horloges T1 à T4.

L'ordonnancement statique S0 est configuré de la manière suivante: pendant le premier cycle d'horloge T1, la première unité de traitement PE₁ réalise la première opération op_{1,1} . Parallèlement, la deuxième unité de traitement PE₂ réalise la deuxième opération op_{2,1}. Parallèlement, la troisième unité de traitement PE₃ réalise la troisième opération op_{3,1}. Parallèlement, la quatrième unité de traitement PE₄ réalise la quatrième opération op_{4,1}. Pendant le deuxième cycle d'horloge T2, la première unité de traitement PE₁ réalise la quatrième opération op_{1,2} . Parallèlement, la deuxième unité de traitement PE₂ réalise la cinquième opération op_{2,2}. Parallèlement, la troisième unité de traitement PE₃ réalise la sixième opération op_{3,2}. Parallèlement, la quatrième unité de traitement PE₄ réalise la septième opération op_{4,2}. De même, les unités de traitement PEᵢ fonctionnement parallèlement pendant les cycles d'horloge suivants. D'une manière générale, l'ordonnancement statique S0 reçu est organisé tel que chaque opération de calcul op_{i,j} est réalisée par la i^{ème} unité de traitement PEᵢ pendant le j^{ème} cycle d'horloge.

La deuxième étape ii) consiste à recevoir au moins un modèle de fautes appliqué à l'ordonnancement statique parallèle S0. La figure 3a illustre un premier exemple F1 d'un modèle de fautes compatible avec le procédé P1. Le modèle F1 comprend une « faute simple », notée f, localisée dans l'espace et dans le temps. La faute f1 impacte uniquement l'opération op_{2,2} réalisée par l'unité de traitement PE₂ au cycle d'horloge T2.

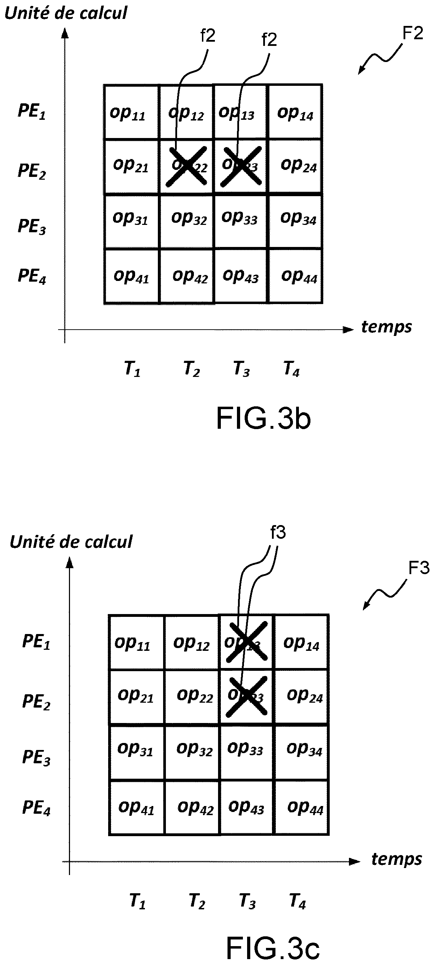

La figure 3b illustre un deuxième exemple F2 d'un modèle de fautes compatible avec le procédé P1. Le modèle F2 comprend une « faute avec propagation temporelle », notée f2. La faute f2 impacte les opérations op_{2,2} et op_{2,3} réalisées par l'unité de traitement PE₂ respectivement pendant les cycles d'horloge T2 et T3. Ainsi, la « faute avec propagation temporelle » n'est pas un évènement ponctuel mais peut affecter des opérations de calcul à des instants différents.

La figure 3c illustre un troisième exemple F3 d'un modèle de fautes compatible avec le procédé P1. Le modèle F3 comprend une « faute avec propagation spatiale », notée f3. La faute f3 impacte les opérations op_{1,3} et op_{2,3} réalisées simultanément pendant le cycle d'horloge T3 et respectivement par les unités de traitement PE₁ et PE₂. Ainsi, la « faute avec propagation spatiale » n'est pas un évènement localisé dans la matrice d'unités de traitement. Plusieurs unités de traitement sont impactées simultanément par la faute f3. A titre d'exemple, une faute avec propagation spatiale correpond à un bruit qui se propage rapidement dans une pluralité de PEᵢ.

Alternativement, il est possible que la faute impactant l'unité de traitement PE₁ soit différente de celle impactant l'unité de traitement PE₂. On parle dans ce cas de fautes simultanées.

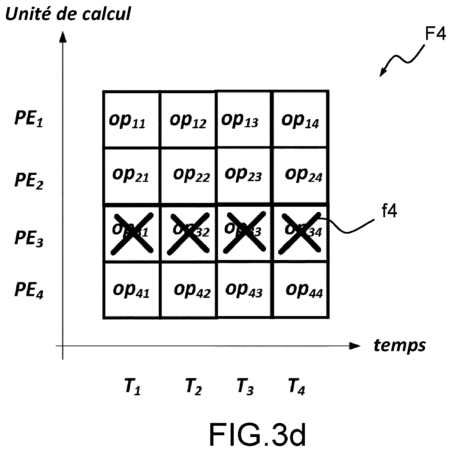

La figure 3d illustre un quatrième exemple F4 d'un modèle de fautes compatible avec le procédé P1. Le modèle F4 comprend une « faute avec propagation temporelle », notée f4. La faute f4 impacte toutes les opérations exécutées par l'unité de traitement PE₃ à savoir les opérations op_{3,1} op_{3,2} op_{3,3} et op_{3,4}. Ce modèle de faute correspond à une fautre permanente sur le PE₃.

D'une manière générale, le modèle de faute comprend une pluralité de fautes f déterminées par trois paramètres : le composant impacté par la faute, l'instant de l'injection de la faute et des informations décrivant la nature de la faute.

Dans le cadre de l'invention, le composant impacté par la faute peut être, à titre illustratif et non limitatif, une unité de traitement PEᵢ, un point mémoire d'une des mémoires, ou des réseau d'interconnexion reliant les composants, le réseau de distribution du signal horloge CLK, un signal de contrôle (CTRL) responsable pour l'ordonnancement ou un registre de stockage temporaire d'une donnée, d'une entrée ou d'une sortie.

Les types de fautes dans un modèle de fautes compatible avec l'invention couvrent à titre d'exemples non limitatifs : le blocage d'un noeud à un état logique (en Anglais « stuck at » fault), l'inversement de l'état logique d'un bit (en Anglais « bit flip » fault), le court-circuit d'une connexion électrique.

Dans le cas d'une faute de type blocage d'un noeud à un état logique, ledit noeud (ou une pluralité de noeuds) transmet toujours une valeur logique constante indépendamment des opérations de calcul. Dans le cas d'une faute de type inversement de l'état logique d'un bit, le composant impacté est un point mémoire (local à un PE, intermédiaire ou global). Le point mémoire impacté est supposé stocker un état logique haut mais il se trouve à un état logique bas et inversement.

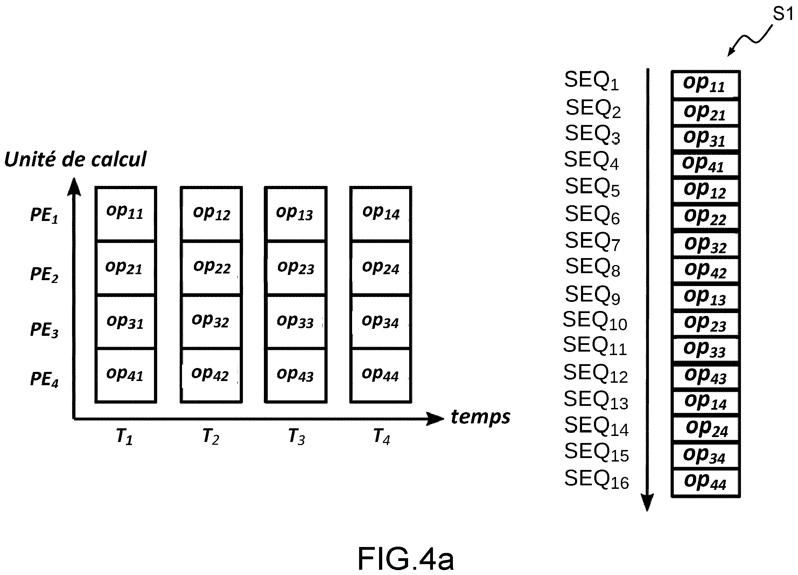

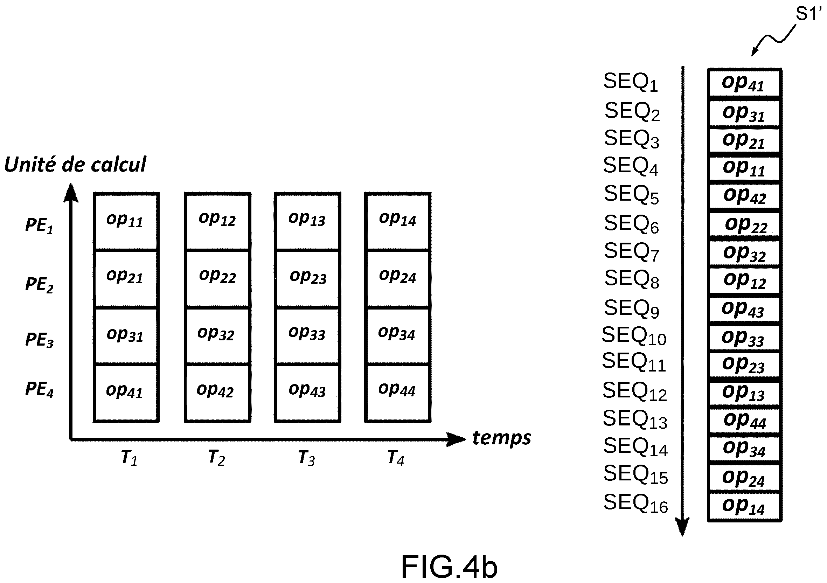

La troisième étape iii) consiste à générer une séquence d'exécution en série S1 à partir de l'ordonnancement statique. La séquence d'exécution en série S1 produit le même résultat que l'ordonnancement parallèle. En effet, les opérations parallèles peuvent également être exécutées de manière séquentielle, sans changer le résultat du calcul. Il existe plusieurs ordonnancements séquentiels en série équivalents à l'exécution parallèle. Dans l'exécution séquentielle, si op_{i,j} est exécuté avant op_{k.l}, quand j<l, le résultat séquentielle sera équivalente. En faisant une analyse plus détaillée de la dépendance des données entre les PEs, une contrainte moins forte peut suffire pour garantir cette équivalence. D'une manière générale, une opération dépendant d'une opération antérieure dans l'ordonnancement parallèle, ne peut pas être exécutée avant ladite opération antérieure dans l'ordonnancement en série généré. Les figures 4a et 4b illustrent respectivement deux séquences d'exécution en série S1 et S1' équivalentes à l'ordonnancement statique parallèle de la figure 2. Chaque opération opᵢⱼ de l'ordonnancement statique parallèle est associée à une étape en série notée SEQₓ avec x l'ordre du cycle d'horloge d'exécution de ladite opération dans la séquence d'exécution en série.

Dans la suite de la description, le modèle de faute F4 est retenu pour décrire le déroulement du procédé P1 à titre d'exemple illustratif et non limitatif.

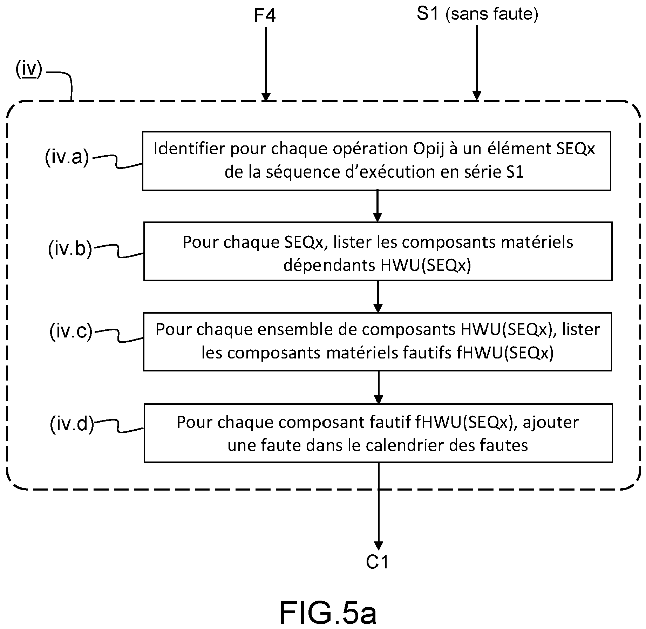

La quatrième étape iv) consiste à générer un calendrier d'injection de fautes noté C1. La figure 5a illustre un organigramme des sous-étapes de la génération du calendrier de fautes dans le procédé selon l'invention. Le modèle de fautes F4 est un ensemble de fautes f_{i',j'} tel que i' est l'indice du composant impacté par la faute et j est l'indice du cycle d'horloge correspondant à l'instant d'apparition de la faute.

La première sous-étape iv.a) consiste à identifier chaque opération de calcul op_{i,j} par un premier indice i=1 à N correspondant au rang de l'unité de traitement PEᵢ exécutant ladite opération et par un second indice j=1 à M correspondant au cycle d'horloge Tⱼ d'exécution de ladite opération selon l'ordonnancement statique parallèle S0. Ainsi, à chaque opération op_{i,j} correspond son élément SEQx, dans la séquence d'exécution en série S1.

La deuxième sous-étape iv.b) consiste à itérer pour chaque SEQx la génération de la liste des composants matériels, HWU(SEQx), utilisés lors de l'exécution de ladite opération. Le résultat de la fonction HWU(SEQx) est un sous-ensemble de la liste des composants du circuit intégré CE. A titre d'exemple, si l'opération op_{2,2} est exécuté à l'étape séquentielle SEQ6 et elle et mise en oeuvre par l'unité de traitement PE₂ et par le point mémoire mem1 de la mémoire globale MEM, on obtient HWU (SEQ₆)={ PE₁ , mem1 }.

La troisième sous-étape, iv.c) consiste à déterminer si les unités matérielles utilisées par l'opération op_{i,j} sont assujetties à une faute. La liste des fautes qui touchent les unités matérielles utilisées par SEQₓ est désignée fHWU(HWU(SEQx)). Dans l'exemple précédent, si uniquement le PE2 est assujetti à un faute pendant l'opération op_{2,2} alors fHWU(HWU(SEQx)) = { PE2 }.

La quatrième sous-étape iv.d) consiste à générer un calendrier de fautes en associant à chaque faute f_{i',j'} du modèle F4 au moins une opération de calcul op_{i,j}.. Cela est réalisé en insérant la faute qui impacte l'opération op_{i,j} après les fautes déjà présent dans le calendrier des fautes.

Avantageusement, la quatrième étape iv) comprend en outre une sous-étape supplémentaire consistant à calculer pour chaque opération SEQₓ, impactée par une faute, le nombre d'opérations de calcul la séparant de l'opération SEQₓ₊₁ impactée par faute suivante du calendrier de faute.

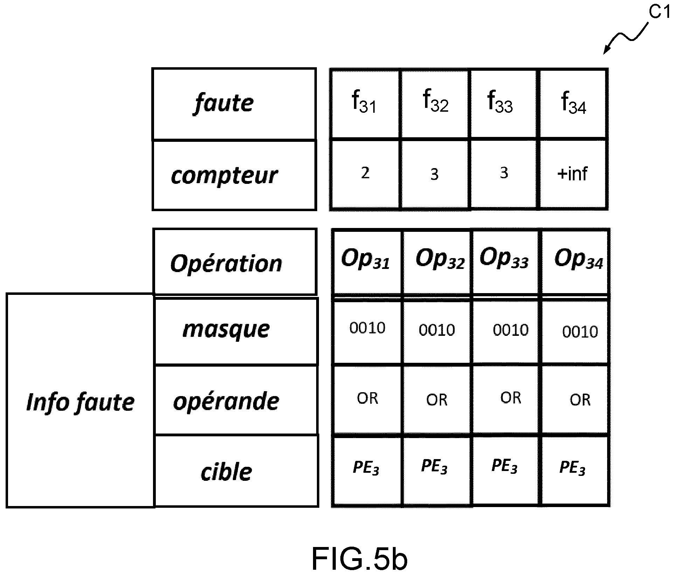

La figure 5b illustre un exemple d'un calendrier de faute C1 obtenu suite à la réception de l'ordonnancement statique parallèle S0 de la figure 2 et le modèle de fautes F4 de la figure 3d. Pour chaque faute, le compteur est configuré pour contenir le nombre d'opérations de calcul prévues entre l'injection d'une faute et l'injection de la faute suivante dans un déroulement séquentiel en série. La première faute à injecter f₃₁ correspond à la troisième opération de calcul dans un déroulement séquentiel en série. Ainsi, le compteur est initialisé à 2. La deuxième faute f₃₂ correspond à la septième opération dans un déroulement séquentiel en série ainsi, le compteur contient la valeur de 3 pour la faute f₃₂. Le même raisonnement s'applique pour la troisième faute f₃₃ et la quatrième faute f₃₄.

Afin d'émuler une faute sur une variable logicielle d'un programme qui simule le système et non dans un noeud matériel du circuit, on applique des opérations de masquage logique sur une donnée d'entrée ou une donnée de sortie de l'opération de calcul opᵢⱼ associées à la dite faute. A titre d'exemple, le blocage du bit de rang 1 de la variable A à un état logique 1 est modélisable par l'application du masque logique suivant : A <- A OR 0010. Le blocage du bit de rang 1 à un état logique 0 de la variable B est modélisable par l'application du masque logique suivant : B <- B AND 1101. L'inversement d'état du bit le plus faible du mot de rang N de la mémoire mem1 est réalisé par l'opération suivante : mem1[N] ← mem1[N] XNOR 0001. D'une manière générale, le calendrier de fautes n'est pas limité uniquement à des fautes qui peuvent être modélisées par des opérations logiques.

Le calendrier de faute C1 comprend ainsi pour chaque faute le masque à appliquer, l'opérande logique (OR, XNOR, AND..) et la cible de l'opération afin de simuler l'injection de faute lors de l'exécution.

On suppose que la cible est une donnée dynamique notée x (variable), propagée d'une unité de traitement PE₁ à l'unité de traitement PE₃ tout en passant par l'unité de traitement PE₂. L'effet de l'injection d'une faute impactant l'unité de traitement PE₁ en appliquant un masque sur la variable dynamique x est propagée à travers ladite variable vers les autres unités de traitement. Ainsi, il suffit d'appliquer la faute sur le résultat de l'opération correspondante exécutée par l'unité PE₁ pour simuler son effet global.

Dans le cas où la cible est une donnée statique notée y (constante), utilisée par les trois unités de traitement PE₁ à PE₃, l'effet d'une faute impactant l'unité de traitement PE₁ n'est pas automatiquement propagée. En effet, pendant une exécution séquentielle en série, la donnée statique y est chargée à chaque cycle d'horloge Tⱼ dans le logiciel de simulation. Ainsi, l'injection d'une faute impactant uniquement pour l'opération exécutée par PE₁ ne permet plus de propager l'effet de cette faute vers les unités de traitement PE₂ et PE₃. D'où la nécessité d'ajouter dans le calendrier de fautes C1, deux injections de fautes supplémentaires afin de tenir compte de l'effet de la faute associée à l'unité PE₀ sur la donnée statique réutilisée par les unités de traitement PE₂ et PE₃.

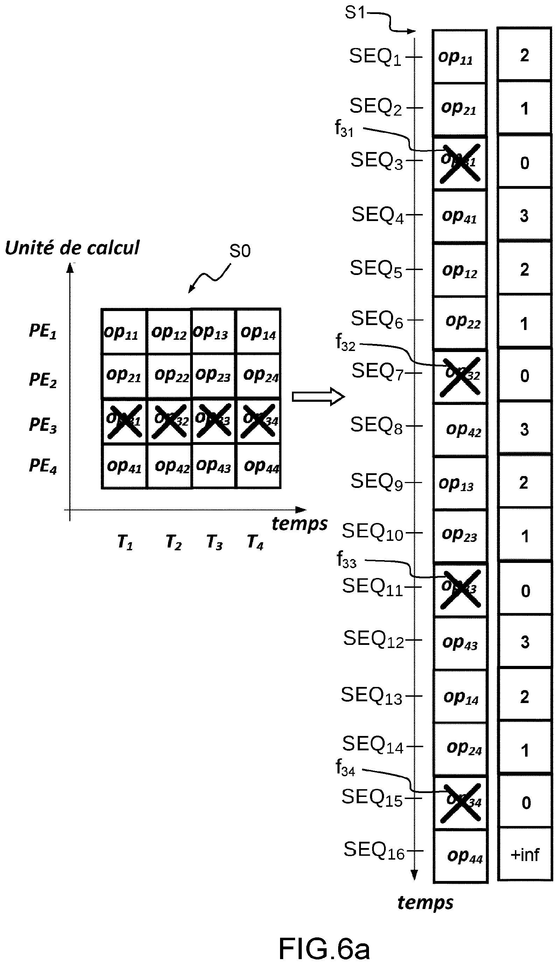

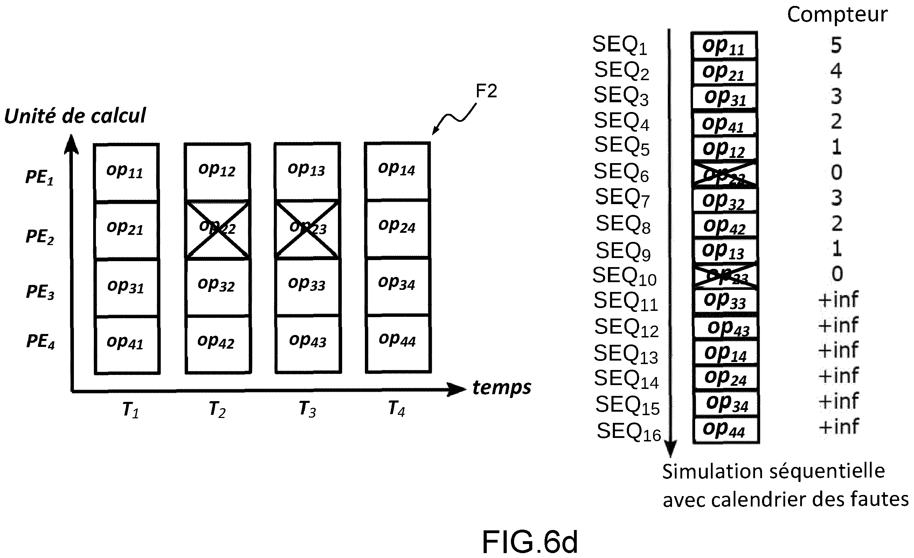

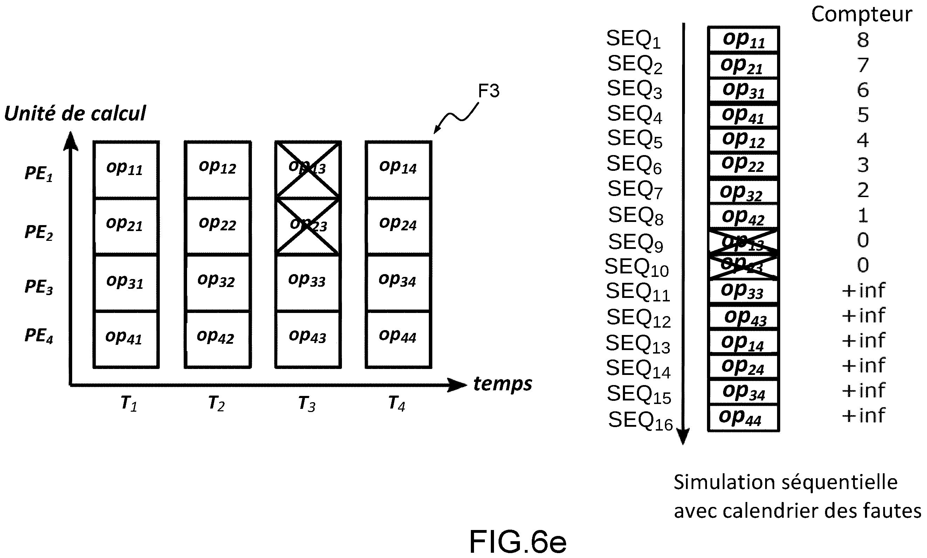

L'exemple de la figure 6a illustre le cas où l'on suppose que le bit de rang 1 du résultat calculé par PE₃ est toujours bloqué à 1.

La cinquième étape v) consiste à exécuter la séquence d'exécution S1 en série par un processeur. L'exécution en série de la séquence S1 est accompagnée par une injection des fautes organisée selon le calendrier de fautes C1. Plus particulièrement, le compteur est initialisé à la première valeur cont=2 associée à la première faute f₃₁. A chaque opération de calcul exécutée par le processeur, le compteur est décrémenté d'une unité. Lorsque le compteur arrive à 0, le masque correspondant à la faute f₃₁ est appliqué à la cible indiquée dans le calendrier de fautes C1. La faute f₃₁ étant appliquée, le compteur est réinitialisé à la valeur cont=3 associée à la deuxième faute f₃₂ en attente d'injection. Ainsi après l'exécution des opérations op₄₁ à op₂₂ séquentiellement, le compteur est à une valeur cont=0. Le processeur exécute l'opération op₃₂ tout en injectant la faute f₃₂ par application du masque logique et de l'opérande associée à ladite faute sur la cible récupérée du calendrier C1. Le même mécanisme est réitéré jusqu'à l'injection de toutes les fautes listées dans le calendrier et l'achèvement de la séquence d'exécution S1.

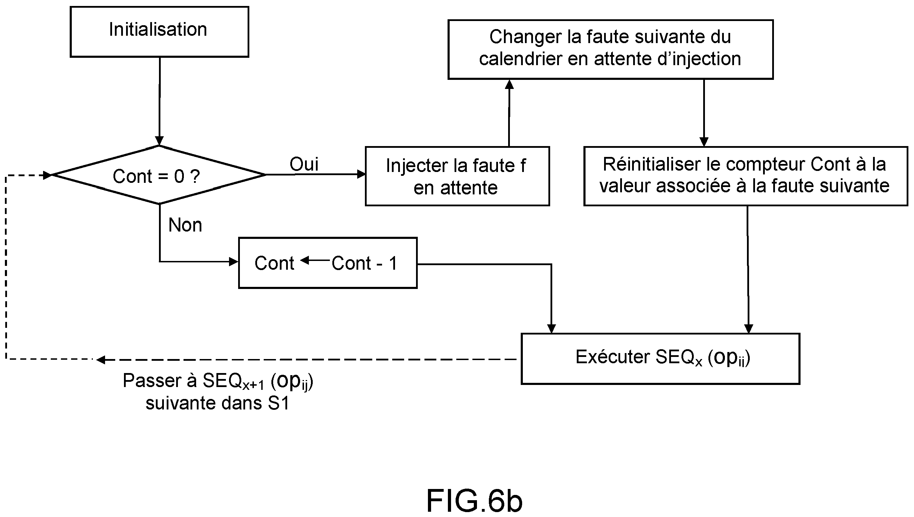

La figure 6b illustre un organigramme du mécanisme de contrôle de l'injection de fautes décrit précédemment.

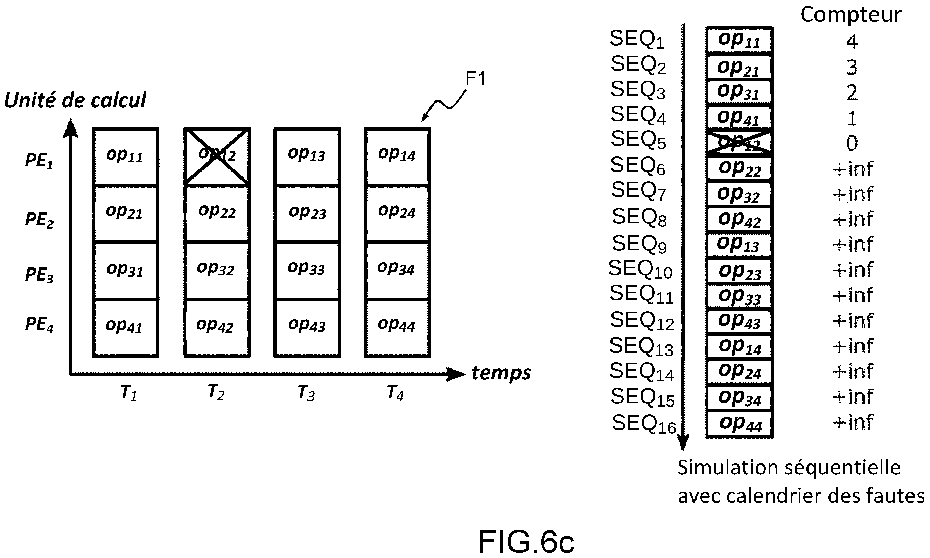

Les figures 6c à 6e illustrent les respectivement les séquences d'exécution en série avec une injection des fautes provenant respectivement des modèles de fautes F1, F2 et F3. Lesdites séquences sont obtenues par le procédé selon l'invention tel que décrit préalablement.

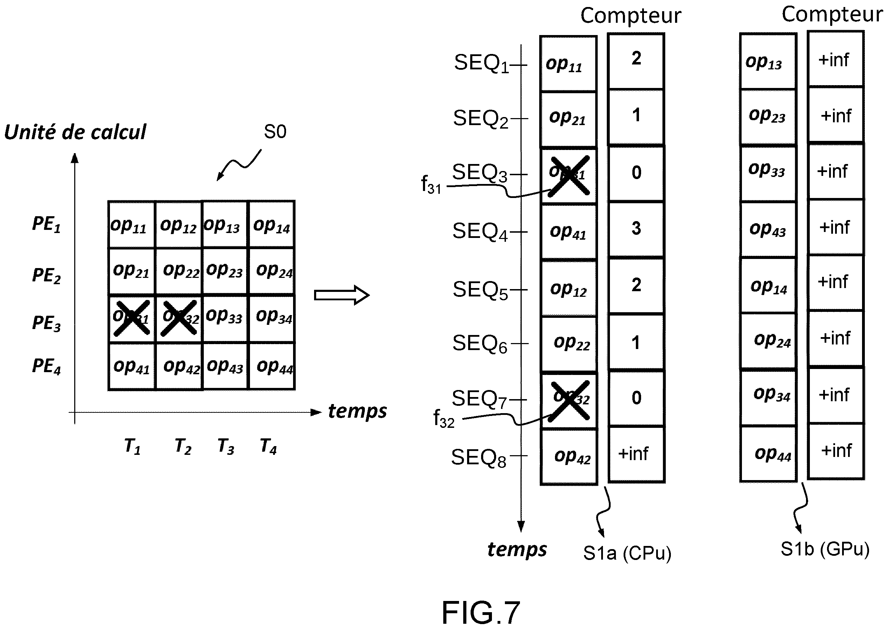

La figure 7 illustre une séquence d'exécution en série des opérations de calcul avec une injection de fautes selon le calendrier selon un second mode de réalisation l'invention.

Alternativement, il est possible de diviser la séquence d'exécution S1 en au moins deux sous-séquences S1a et S1b. La première sous-séquence S1 acomprend des opérations associées à des injections de fautes selon le calendrier de fautes C1. La seconde sous-séquence S1b ne comprend pas des opérations associées à des injections de fautes selon le calendrier de fautes C1. La première sous-séquence S1a nécessite plus de précision de calcul pour simuler l'effet des fautes injectées. Ainsi, la première sous-séquence S1a est exécutée par un processeur de type unité centrale de traitement (CPU acronyme de Central Processing Unit). La seconde sous-séquence d'exécution S1b est exécutée par un multi-processeur tel qu'un processeur graphique (GPU acronyme de Graphic Processing Unit) présentant moins de contrôle sur l'exécution temporelle pour une plus grande vitesse d'exécution.

La sixième étape vi) consiste à évaluer le résultat final de l'exécution en série avec injection de fautes à un résultat attendu. Cette étape sert à évaluer l'effet applicatif global de la faute qui a été simulée. Plusieurs fautes peuvent être simulées, constituant une campagne d'injection de fautes injectées par voie logicielle. À titre d'exemple, on suppose que le circuit testé CE met en oeuvre un algorithme de calcul d'un réseau de neurones artificiels conçu pour la reconnaissance d'un piéton par une voiture autonome. L'impact d'une faute appliquée à un composant prédéterminé est évalué en comparant le résultat de l'exécution de l'algorithme par un processeur avec injection de faute à un résultat connu (piéton détecté ou non). On reproduit ainsi l'effet d'une ou plusieurs fautes matérielles, par une injection logicielle. Cela permet de prédire l'impact des fautes injectées sur le comportement global du circuit en émulant ce comportement par un processeur. Un avantage de l'invention est d'éviter les simulations électroniques au niveau d'une description matérielle du circuit (RTL) afin d'évaluer la robustesse du circuit dans son contexte applicatif.

De plus, le procédé selon l'invention permet de simuler des modèles de fautes non-déterministes où au moins un paramètre de la faute injecté est aléatoire. Il est possible ainsi de simuler à titre d'exemple un modèle de fautes F où l'instant d'apparition d'une faute est aléatoire avec un composant fautif prédéterminé et un type de faute prédéterminé. De même, il est possible de générer un modèle de fautes F avec un composant fautif choisi aléatoirement. Une fois le modèle de fautes est généré et reçu suite à l'étape ii), les étapes restantes iii) à vi) se déroulent de la même manière préalablement décrite.

De plus, le procédé de génération du calendrier des fautes selon l'invention peut être réalisé par un outil ou un logiciel.

De plus, un circuit de type réseau prédiffusé programmable (FPGA = Field Programmable Gate Array), est une forme de calculateur parallèle et ainsi, le calendrier des fautes peut être utilisé pour évaluer l'impact de fautes matérielles sur ce type de circuit.

## Revendications

1. Procédé (P1), mis en oeuvre par ordinateur, de test de fiabilité d'un circuit (CE) comprenant un ensemble de composants électroniques, ledit ensemble comprenant une pluralité d'unités de traitement (PE) de rang i=1 à N et configurés pour exécuter en parallèle des opérations de calcul (op_{i,j}) selon un ordonnancement statique parallèle prédéterminé (S0), ledit procédé comprenant les étapes suivantes :
i. recevoir une distribution des opérations de calcul (op_{i,j}) selon l'ordonnancement statique ;
ii. recevoir au moins un modèle de fautes (F1, F2, F3, F4) appliqué à l'ordonnancement statique ;
iii. générer une séquence d'exécution en série (S1) à partir de l'ordonnancement statique parallèle (S0)) ;
iv. générer un calendrier (C1) d'injection de fautes ;
v. exécuter la séquence d'exécution (S1) en série avec injection de faute à partir du calendrier de fautes (C1) par un processeur (PROC) ;
vi. évaluer le résultat final de l'exécution par rapport à un résultat attendu.

2. Procédé (P1) selon la revendication 1 dans lequel l'injection de faute lors de l'exécution de la séquence d'exécution (S1) est déclenchée par un compteur (cont) configuré pour compter le nombre d'opérations de calcul (op_{i,j}) prévues entre l'injection d'une faute et l'injection de la faute suivante.

3. Procédé (P1) selon l'une quelconque des revendications 1 ou 2 dans lequel chaque faute du modèle de fautes (F1, F2, F3, F4) est **caractérisée par** trois paramètres : au moins un composant électronique du circuit (CE) impacté par la faute, un type de faute et un instant d'injection de la faute dans l'ordonnancement statique prédéterminé (S0).

4. Procédé (P1) selon la revendication 3 dans lequel l'étape iii) comprend les sous-étapes suivantes :
iii.a) identifier chaque opération de calcul (op_{i,j}) par un premier indice correspondant au rang de l'unité de traitement (PEᵢ) exécutant ladite opération et par un second indice correspondant à l'instant d'exécution de ladite opération selon l'ordonnancement statique parallèle ;
iii.b) déterminer pour chaque opération de calcul (op_{i,j}) un ensemble des composants utilisés lors de l'exécution de ladite opération ;
iii.c) générer un calendrier de fautes en associant à chaque faute du modèle au moins une opération de calcul selon la comparaison entre :
- d'une part l'ensemble des composants impactés par ladite faute et d'autre part l'ensemble des composants utilisés par l'au moins opération de calcul.

5. Procédé (P1) selon l'une quelconque des revendications 3 ou 4 dans lequel la séquence d'exécution en série (S1) est décomposée en deux groupes de sous-séquences (S1a,S1b), les opérations de calcul associées à des fautes étant disposées dans les sous-séquences du premier groupe ;
chaque sous-séquence d'exécution (S1a) du premier groupe étant exécutée lors de l'étape v) par un processeur de type unité centrale de traitement (CPU) ;
chaque sous-séquence d'exécution (S1b) du second groupe étant exécutée lors de l'étape v) par un processeur graphique (GPU).

6. Procédé (P1) selon l'une quelconque des revendications 3 à 5 dans lequel l'injection de fautes lors de l'étape v) est réalisée par l'application d'une opération de masquage logique sur une donnée d'entrée ou une donnée de sortie de l'opération de calcul (opᵢⱼ) associées à la dite faute (fᵢⱼ).

7. Procédé (P1) selon l'une quelconque des revendications 3 à 6 dans lequel le type d'une faute est choisi parmi le blocage d'un noeud à un état logique, l'inversement de l'état logique d'un bit, le court-circuit d'une connexion électrique.

8. Procédé (P1) selon l'une quelconque des revendications 3 à 7 dans lequel le composant impacté par la faute est une unité de traitement (PEᵢ) ou une mémoire de stockage (MEM) ou une connexion électrique ou un réseau de distribution d'un signal horloge.

9. Procédé (P1) selon l'une quelconque des revendications 3 à 7 dans lequel au moins un des paramètres modèle de fautes (F1) est généré d'une manière aléatoire.

10. Procédé (P1) selon l'une quelconque des revendications précédentes dans lequel le circuit (CE) est configuré pour mettre en oeuvre un réseau de neurones artificiels, et dans lequel les unités de traitement (PE) sont des circuits multiplieurs-accumulateurs configurés pour calculer des sommes de données pondérées par des coefficients synaptiques.

11. Dispositif de test de fiabilité d'un circuit (CE) comprenant un ensemble de composants électroniques, ledit ensemble comprenant une pluralité d'unités de traitement (PE) de rang i=1 à N et configurés pour exécuter en parallèle des opérations de calcul (op_{i,j}) selon un ordonnancement statique parallèle prédéterminé (S0), ledit dispositif étant configuré pour exécuter les étapes du procédé (P1) selon l'une quelconque des revendications 1 à 10.

12. Dispositif de test selon la revendication 11, comprenant un processeur de type unité centrale de traitement (CPU) et un processeur graphique (GPU) ; ledit dispositif de test étant configuré pour exécuter les étapes du procédé (P1) selon la revendication 5.

13. Programme d'ordinateur comprenant des instructions qui, lorsque le programme d'ordinateur est exécuté par le dispositif de test selon l'une quelconque des revendications 11 ou 12, conduisent ledit dispositif de test à mettre en oeuvre le procédé de test selon l'une quelconque des revendications 1 à 10.
